# EUROPEAN PATENT SPECIFICATION

(11) **EP 4 369 390 B1**
(45) Date of publication and mention of the grant of the patent: **19.02.2025**
(21) Application number: 22207205.0
(22) Date of filing: 14.11.2022
(51) Int. Cl.: H01L 23/367, B81B 7/00, H01L 23/498

(54) **A SEMICONDUCTOR DEVICE COMPRISING A GRAPHENE-BASED CONTACT SWITCH FOR COOLING**
HALBLEITERANORDNUNG MIT EINEM GRAPHEN-BASIERTEN KONTAKTSCHALTER ZUR KÜHLUNG
DISPOSITIF SEMI-CONDUCTEUR COMPRENANT UN COMMUTATEUR DE CONTACT À BASE DE GRAPHÈNE POUR LE REFROIDISSEMENT

(43) Date of publication of application: 15.05.2024
(73) Proprietor: Huawei Technologies Co., Ltd., Shenzhen, Guangdong 518129 (CN)
(72) Inventor: Muller, Philippe, 80992 Munich (DE)
(74) Representative: Roth, Sebastian

(56) References cited:
- US-A1- 2017 345 732
- SHARMA PANKAJ ET AL: "Electromagnetic Performance of RF NEMS Graphene Capacitive Switches", IEEE TRANSACTIONS ON NANOTECHNOLOGY, IEEE, USA, vol. 13, no. 1, 1 January 2014 (2014-01-01), pages 70 - 79, XP011536774, ISSN: 1536-125X, [retrieved on 20140106], DOI: 10.1109/TNANO.2013.2290945

## Description

### TECHNICAL FIELD

The disclosure relates to cooling of a semiconductor device. The disclosure proposes a semiconductor device, and a corresponding method for fabricating the semiconductor device. The semiconductor device comprises an active section and an interposer section comprising one or more vias and the means for transferring heat from the active section to the one or more vias.

### BACKGROUND

3D integration for advanced node semiconductor CPU chips is requiring more and more through-silicon via (TSV) interconnects in respective substrates and/or interposers. Conventionally, some TSVs can drain generated heat from the front-end-of line (FEOL). However, TSVs not connected to the back-end-of line (BEOL), for example, dummy TSVs, will not contribute to the thermal resistance reduction of the substrate. Further, TSVs can have parasitics that can be detrimental to the system performance, especially the parasitic capacitance that can lead to IR drops (Voltage drops in power lines).

TSVs influence adjacent active devices since TSVs produce a stress field that can propagate and impact active devices, for example the carrier mobility of fin field-effect transistors (FINFETs). Therefore, keep-out zones are implemented around TSVs to avoid large variability in the circuit of active devices, which can lead to a floor plan penalty for using conventional TSVs.

Further, TSVs can introduce parasitic components to the circuit, due to the oxide liner required to isolate the TSVs from the substrate. This induces high capacitance loading to the circuit. If unnecessary TSVs are connected, this may induce extra capacitance that will have an impact on the efficient powering of the active circuits. This may also increase power consumption of the chip. US Patent Application US 2017/345732 A1 discloses a semiconductor device with an interposer.

SHARMA PANKAJ ET AL: "Electromagnetic Performance of RF NEMS Graphene Capacitive Switches", IEEE TRANSACTIONS ON NANOTECHNOLOGY, IEEE, USA, vol. 13, no. 1, 1 January 2014 (2014-01-01), pages 70-79, discloses MEMS/NEMS contact switches with graphene membranes for general use.

### SUMMARY

In view of the above, this disclosure aims to provide efficient cooling of a semiconductor device, for example of the active components of the semiconductor device, while minimizing drawbacks of the cooling mechanism. One objective is to reduce parasitic loading caused by the extra capacitance linked to vias. Another objective is to reduce mechanical stress of the vias, which induce the need for keep out zones for active components around the vias.

These and other objectives are achieved by this disclosure as described in the enclosed independent claims. Advantageous implementations are further defined in the dependent claims.

A first aspect of this disclosure provides a semiconductor device comprising an active section, an interposer section arranged on the active section, and one or more nanoelectromechanical systems or microelectromechanical systems (NEMS/MEMS) contact switches arranged between the interposer section and the active section, wherein the interposer section comprises one or more vias, for example, through-silicon vias (TSVs), wherein the active section comprises at least a part of each contact switch of the one or more contact switches, wherein each contact switch of the one or more contact switches comprises a graphene membrane, and wherein each contact switch of the one or more contact switches is configured to be switched between a first switching state, in which the graphene membrane of the contact switch is thermally connected to a respective via of the one or more vias of the interposer section, and a second switching stage, in which the graphene membrane of the contact switch is thermally disconnected from the respective via of the one or more vias of the interposer section.

The term "thermally connected" may refer to being directly thermally connected. Two components being "thermally connected" may include that said components are directly physically connected and/or attached to each other. For example, said components may be directly adjacent to each other. The term "thermally connected" may not include only being connected by gas molecules and/or radiation. The term "thermally connected" may refer to two solid components being in direct physical contact with each other, wherein said contact allows for direct heat transfer.

The one or more vias may be thermal vias or thermal TSVs. The term "thermal" may refer to the thermal conductivity of the vias.

The interposer section may be positioned on top of the active section.

Parasitics of the one or more vias can be temporally avoided if a thermal connection to the one or more vias is temporally not required for cooling.

The interposer section may comprise, for each contact switch, at least a part of the contact switch, for example the one or more drive electrodes, which may or may not be comprised in the contact switch. There may be no stress coupling to active components in the semiconductor device.

The one or more contact switches may be comprised in the active section except of, for example, one or more electrodes, for example one or more drive electrodes. Alternatively, the one or more contact switches may be comprised in the active section.

For each contact switch, the contact switch may be arranged between residual parts of the interposer section and active section. The term "residual parts" may refer to parts of the interposer section and/or active section that are not comprised in the contact switch.

The semiconductor device may comprise one or more other vias and/or one or more dummy vias. For example, the one or more other vias may always be thermally connected to the active section and/or the one or more dummy vias may always be thermally disconnected from the active section.

In a further implementation form of the first aspect, the semiconductor device further comprises a controller configured to selectively control one contact switch, or some contact switches, or all contact switches to the first switching state or the second switching state.

For example, depending on a workload, temperature, and/or temperature distribution of the semiconductor device, different contact switches may be controlled. Thus, the thermal connection of the semiconductor device may be adaptively tuned.

In a further implementation form of the first aspect, the graphene membrane of each contact switch is a freestanding graphene membrane if the graphene membrane is not thermally connected to the respective via.

In a further implementation form of the first aspect, for each contact switch, the graphene membrane is part of an actuator of the contact switch.

In a further implementation form of the first aspect, each contact switch comprises two hinges, wherein each hinge comprises a first hinge part and a second hinge part, and wherein at least a part of the graphene membrane of that contact switch is sandwiched between the second hinge part and the first hinge part.

In a further implementation form of the first aspect, the active section comprises the graphene membranes of the one or more contact switches, and/or wherein each graphene membrane of the one or more contact switches is directly attached to the active section.

In a further implementation form of the first aspect, each via of the one or more vias is directly attached to the interposer section, for example a residual part of the interposer section.

The residual part of the interposer section may be the part of the interposer section that does not comprise the one or more vias.

In a further implementation form of the first aspect, for each contact switch, the respective vias is attached to the graphene membrane if the graphene membrane is thermally connected to the respective via.

In a further implementation form of the first aspect, for each contact switch, the interposer section comprises one or more drive electrodes and the active section comprises one or more counter drive electrodes, or wherein, for each contact switch, the interposer section comprises one or more counter drive electrodes and the active section comprises one or more drive electrodes.

The interposer section may comprises two drive electrodes for each contact switch. The active section may comprise one counter drive electrode for each contact switch.

Each contact switch may further comprise the one or more drive electrodes and/or the one or more counter drive electrodes. Alternatively or additionally, each contact switch may not comprise the one or more drive electrodes and/or the one or more counter drive electrodes.

In a further implementation form of the first aspect, the active section comprises one or more drive voltage pads, wherein each drive voltage pad is electrically connected to the one or more drive electrodes of at least one contact switch.

In a further implementation form of the first aspect, the active section comprises, for each contact switch, at least one NEMS/MEMS bias pad that is electrically connected to the graphene membrane of the contact switch.

In general, for each contact switch, the graphene membrane may be electrically and/or thermally connected to the active section for the first and the second switching state and electrically and/or thermally disconnected from the interposer section in the second switching state.

In a further implementation form of the first aspect, for each contact switch, the one or more drive electrodes are configured to, for example if controlled by the controller, electrically attract the graphene membrane to thermally connect, for example to directly attach, the graphene membrane to the respective via, and wherein, for each contact switch, the one or more counter drive electrodes are configured to, for example if controlled by the controller, electrically attract the graphene membranes to thermally disconnect, for example to detach, the graphene membrane from the respective via.

For each contact switch, a respective voltage may be applied to respective drive voltage pads and/or respective drive electrodes and the at least one NEMS/MEMS bias pads and/or respective graphene membranes to electrically attract the graphene membrane to thermally connect the graphene membrane to the respective via.

For each contact switch, a respective voltage may be applied to respective counter drive electrodes and the at least one NEMS/MEMS bias pads and/or respective graphene membranes to electrically attract the graphene membrane to thermally disconnect the graphene membrane from the respective via.

Alternatively, the one or more drive electrodes and the one or more counter drive electrodes may be switched. The one or more counter drive electrodes may be comprised in the interposer section and the one or more drive electrodes may be comprised in the active section.

In a further implementation form of the first aspect, for each contact switch, for each contact switch, the one or more drive electrodes are configured to, for example if controlled by the controller, electrically attract the graphene membrane to thermally disconnect the graphene membrane from the respective via, and wherein, for each contact switch, the one or more counter drive electrodes are configured to, for example if controlled by the controller, electrically attract the graphene membranes to thermally connect the graphene membrane to the respective via, for example if the interposer section comprises, for each contact switch, the one or more counter drive electrodes.

In a further implementation form of the first aspect, the active section is hybrid bonded to the interposer section and/or wherein the active section comprises one or more pads for hybrid bonding and the interposer section comprises one or more pads for hybrid bonding.

In a further implementation form of the first aspect, the one or more contact switches form at least a part of the interface of the interposer section and the active section.

In a further implementation form of the first aspect, for each contact switch, the respective via comprises a graphene contact for thermally connecting to the graphene membrane of the contact switch.

In a further implementation form of the first aspect, for each contact switch, the one or more drive electrodes are surrounding the respective via from a top view of the semiconductor device, and/or wherein the respective via is electrically disconnected from the one or more drive electrodes.

A second aspect of this disclosure provides a method for fabricating a semiconductor device, wherein the method comprises: providing a substrate for an interposer section, etching one or more trenches into the substrate for the interposer section, filling the one or more trenches to form one or more vias, providing a substrate for an active section, providing one or more graphene membranes on the active section or the interposer section, forming one or more NEMS/MEMS contact switches based on the one or more graphene membranes, wherein each contact switch can be switched between a first switching state and a second switching state, bonding the interposer section to the active section, wherein each contact switch of the one or more contact switches is arranged between the interposer section and the active section and adjacent to a respective via of the one or more via of the interposer section, such that the graphene membrane of the contact switch is thermally connected to the respective via in the first switching state and is thermally disconnected from the respective via in the second switching state.

The interposer section may be positioned on top of the active section. The interposer section may be positioned on the top side of the active section or, for example, if the active substrate is thinned down and has back-side metallization, at the bottom side of the active section. The top side of the active section may be the side that is opposite from the substrate of the active section and the bottom side of the active section may be the side comprising the substrate of the active section.

In a further implementation form of the second aspect, the method further comprises: providing a first layer comprising one or more first electrodes, for example a dielectric layer comprising one or more first electrodes, on top of the substrate for the active section, providing a second layer on top of the first layer comprising one or more sacrificial sections, for example SiO₂ sections, and one or more first hinge parts for the one or more contact switches, providing a third layer on top of the second layer, wherein the third layer comprises, for each first electrode, a first cavity, providing, for each first electrode, into the first cavity a sacrificial layer to cover at least a part of the area on top of each first hinge part of two adjacent first hinge parts and to cover the area on top of the first electrode, growing, for each first electrode, a graphene membrane, for example with chemical vapor deposition (CVD), on top of the sacrificial layer to cover at least a part of the area on top of each first hinge part of the two adjacent first hinge parts and to cover the area on top of the first electrode, depositing, for each first electrode and for each first hinge part of the two adjacent first hinge parts, a second hinge part on top of the first hinge part into the third layer to form a hinge, wherein at least a part of the graphene membrane is sandwiched between the second hinge part and the first hinge part, and releasing, for each first electrode, the graphene membrane based on removing the sacrificial layer and a respective sacrificial section of the one or more sacrificial sections, for example with vapor HF etching.

Layer transfer may not be required for growing, for each contact switch, the graphene membrane.

Thus, graphene may be patterned in a volume manufacturing compatible way, for example without layer transfer.

The graphene membrane of each contact switch may be remain high quality after deposition, for example compared to graphene membranes that are fabricated based on layer transfer.

Alternatively or additionally, the graphene membrane of one contact switch, some contact switches, or all contact switches may be grown based on layer transfer.

For example, while fulfilling the condition that the semiconductor device is sufficiently cooled, the semiconductor device may only comprise some graphene membranes grown without layer transfer, which may lead to higher quality graphene membranes, wherein other graphene membranes may be grown based on layer transfer. The benefits and drawbacks of both processes may be combined.

The sacrificial layer may be a metal catalyst layer.

In a further implementation form of the second aspect, the method further comprises: etching, for each first electrode, a second cavity into the respective sacrificial section of the second layer in an area on top of the first electrode and between two adjacent first hinge parts of the one or more first hinge parts, providing, for each first electrode, a protective material, for example comprising Al₂O₃, on the side walls of the second cavity towards the two adjacent first hinge parts, providing, for each first electrode, a sacrificial material, for example comprising SiO₂, into the second cavity for filling the second cavity and reforming the respective sacrificial section.

In a further implementation form of the second aspect, the method further comprises: providing a protective layer, for example a SiCN layer, on top of the first layer, for example after etching, for each first electrode, the second cavity into the second layer, and providing the second layer comprising the one or more sacrificial sections and the one or more first hinge parts on top of the protective layer.

In a further implementation form of the second aspect, the method comprises: providing the third layer on top of the second layer, wherein, for each first electrode, the first cavity comprises at least a part of the area on top of each first hinge part of the two adjacent first hinge parts and the area on top of the first electrode, and wherein the first cavity exposes the second layer from the top.

In a further implementation form of the second aspect, the one or more first electrodes are counter drive electrodes or drive electrodes.

In a further implementation form of the second aspect, the method further comprises bonding the active section to the interposer section based on hybrid bonding.

The method of the second aspect may have implementation forms that correspond to the implementation forms of the device of the first aspect. The method of the second aspect and its implementation forms achieve the advantages and effects described above for the device of the first aspect and its respective implementation forms.

Further, in this disclosure the term "substrate for the active section" and the term "integrated circuit substrate" may be used interchangeably.

### BRIEF DESCRIPTION OF DRAWINGS

The above described aspects and implementation forms will be explained in the following description of specific embodiments in relation to the enclosed drawings, in which
- FIG. 1: shows a semiconductor device according to an embodiment of this disclosure.
- FIG. 2a: shows a method step of fabricating the interposer section of the semiconductor device according to an embodiment of this disclosure.
- FIG. 2b: shows a method step of fabricating the interposer section of the semiconductor device according to an embodiment of this disclosure.
- FIG. 3a: shows a method step of fabricating the interposer section of the semiconductor device according to an embodiment of this disclosure.
- FIG. 3b: shows a method step of fabricating the interposer section of the semiconductor device according to an embodiment of this disclosure.
- FIG. 4a: shows a method step of fabricating the interposer section of the semiconductor device according to an embodiment of this disclosure.
- FIG. 4b: shows a method step of fabricating the interposer section of the semiconductor device according to an embodiment of this disclosure.
- FIG. 5a: shows a method step of fabricating the interposer section of the semiconductor device according to an embodiment of this disclosure.
- FIG. 5b: shows a method step of fabricating the interposer section of the semiconductor device according to an embodiment of this disclosure.
- FIG. 6a: shows a method step of fabricating the active section of the semiconductor device according to an embodiment of this disclosure.
- FIG. 6b: shows a method step of fabricating the active section of the semiconductor device according to an embodiment of this disclosure.
- FIG. 7a: shows a method step of fabricating the active section of the semiconductor device according to an embodiment of this disclosure.
- FIG. 7b: shows a method step of fabricating the active section of the semiconductor device according to an embodiment of this disclosure.
- FIG. 8a: shows a method step of fabricating the active section of the semiconductor device according to an embodiment of this disclosure.
- FIG. 8b: shows a method step of fabricating the active section of the semiconductor device according to an embodiment of this disclosure.
- FIG. 9a: shows a method step of fabricating the active section of the semiconductor device according to an embodiment of this disclosure.
- FIG. 9b: shows a method step of fabricating the active section of the semiconductor device according to an embodiment of this disclosure.
- FIG. 10a: shows a method step of fabricating the active section of the semiconductor device according to an embodiment of this disclosure.
- FIG. 10b: shows a method step of fabricating the active section of the semiconductor device according to an embodiment of this disclosure.
- FIG. 11a: shows a method step of fabricating the active section of the semiconductor device according to an embodiment of this disclosure.
- FIG. 11b: shows a method step of fabricating the active section of the semiconductor device according to an embodiment of this disclosure.
- FIG. 12: shows a method step of bonding the active section to the interposer section according to an embodiment of this disclosure.
- FIG. 13: shows an exemplary semiconductor device in a second switching state according to an embodiment of this disclosure.
- FIG. 14: shows an exemplary semiconductor device when switching to a first switching state according to an embodiment of this disclosure.
- FIG. 15: shows an exemplary semiconductor device when switching to a second switching state according to an embodiment of this disclosure.

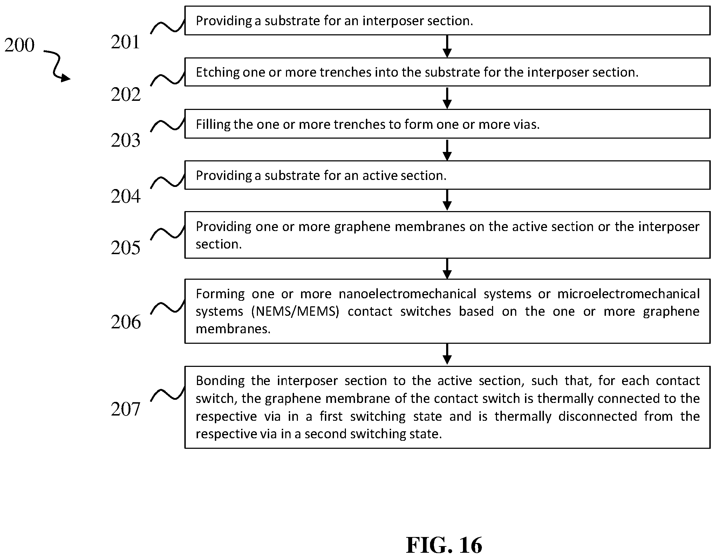

- FIG. 16: shows a method according to an embodiment of this disclosure.

### DETAILED DESCRIPTION OF EMBODIMENTS

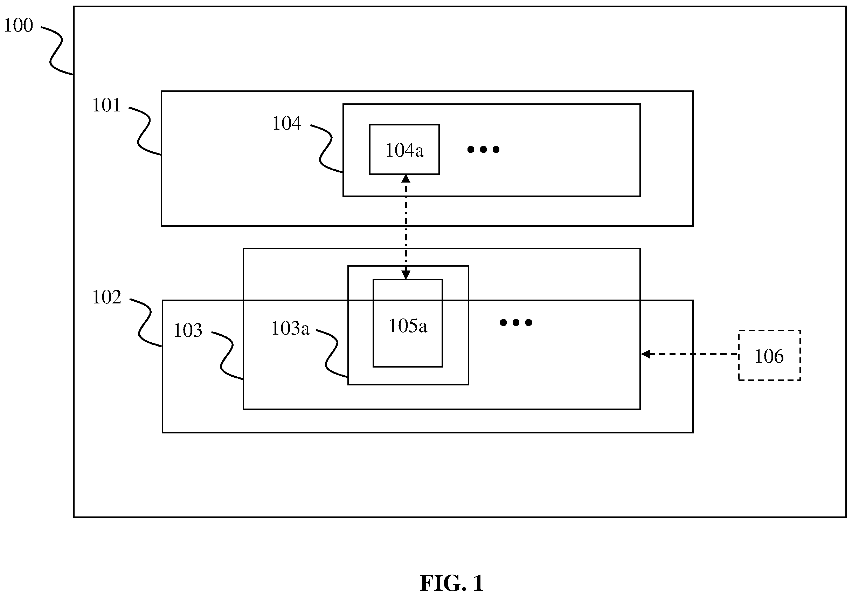

FIG. 1 shows a semiconductor device 100 according to an embodiment of this disclosure. The semiconductor device 100 is shown from a side view. The semiconductor device 100 comprises an interposer section 101, an active section 102, and one or more NEMS/MEMS contact switches 103. The interposer section 101 is arranged on the active section 102 and the one or more contact switches 103 are arranged between the interposer section 101 and the active section 102. The active section 102 comprises at least a part of each contact switch 103a of the one or more contact switches 103.

The interposer section 101 comprises one or more vias 104, for example TSVs, and each contact switch 103a of the one or more contact switches 103 comprises a graphene membrane 105a. Each contact switch 103a of the one or more contact switches 103 is configured to be switched between a first switching state, in which the graphene membrane 105a of the contact switch 103a is thermally connected to a respective via 104a of the one or more vias 104 of the interposer section 101 and a second switching stage, in which the graphene membrane 105a of the contact switch 103a is thermally disconnected from the respective via 104a of the one or more vias 104 of the interposer section 101. The graphene membrane 105a and the respective via 104a being thermally disconnected or thermally connected is represented in FIG. 1 with the dot-dash-arrow connecting the graphene membrane 105a and the respective via 104a.

The semiconductor device 100 may comprise a controller 106 configured to selectively control one contact switch 103a, or some contact switches, or all contact switches 103 to respectively the first switching state or the second switching state.

A semi-damascene integration may be used to deposit and pattern graphene on a semiconductor substrate by the use of a sacrificial layer, for example a sacrificial catalyst metal patterned in an oxide cavity. This may enable the growth of high quality graphene on the sacrificial layer and may allow chemical and mechanical polishing (CMP) to clean carbon deposits on dielectric surfaces.

Each contact switch 103a may be integrated at the interface between the interposer section 101 and the active section 102 and/or in the BEOL that can activate or deactivate a TSV circuit to reduce the parasitics of unneeded TSVs and avoid mechanical interactions of the TSVs with the active section 102, which may save floor plan. This may enable to connect additional thermal TSVs to the BEOL for cooling down parts of the semiconductor device 100, for example active components of the semiconductor device 100.

The one or more contact switches 103 may be mechanical switches and/or may offer extremely low leakage compared to, for example thin film transistors (TFTs). Parts of a CPU can be activated or deactivated to improve power management.

The one or more contact switches 103 may use graphene as a MEMS/NEMS actuator and/or contact material to reduce the driving voltage, for example to achieve compatibility with 1.7V power supplies, and to have a high electrical/thermal conductivity material to contact the vias 104, for example, thermal TSVs. A double drive electrode and a graphene to graphene contact for each contact switch 103a can enhance the reliability and lifetime of the one or more contact switches 103.

An example of a fabrication process is described below. Manufacturing steps may be required for the interposer section 101 and the active section 102, which may be based on a metal-oxide-semiconductor (CMOS) wafer. The process flow is an example of successive steps to realize the structure, these steps may be re-arranged in a different order.

For the following description of fabricating the interposer section 101, a substrate of the interposer section 101 is considered to be at the bottom of the interposer section 101, wherein layers are provided on top, for example in an opposite direction than the bottom, of said substrate. After bonding the interposer section 101 to the active section 102, only the reference frame of the active section 102 may be considered. For example, after bonding, the substrate of the interposer section 101 may be considered to be on top of the semiconductor device 100.

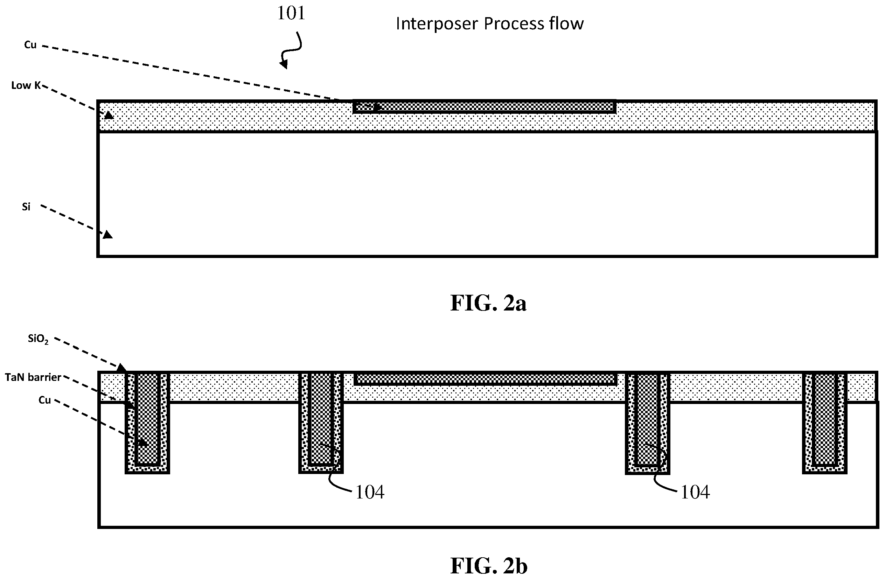

FIG. 2a shows forming drive electrode interconnects using, for example a damascene process, for one or more drive electrodes. This may comprise the deposition of a dielectric layer (denoted as Low K) on the substrate of the interposer section 101, for example by chemical vapor deposition (CVD), plasma enhanced CVD (PECVD), atomic layer deposition (ALD) or other methods, followed by a lithography step and a dielectric etch step to form a cavity in the dielectric. After a polymer mask strip, a metal stack may be deposited by sputtering, ALD, CVD or other methods, to form a barrier layer of a seed layer, for example a Cu seed layer. Electroplating may then be performed to fill the cavity in the dielectric. Thermal anneal and CMP may then be performed to define the drive electrode interconnects. The substrate of the interposer section 101 may be a silicon substrate.

FIG. 2b shows forming one or more vias 104, for example TSVs, by, for example, deep silicon etching (DSiE). A liner, for example SiO₂, may be deposited by, for example ALD or PECVD, to isolate the interposer substrate from the one or more vias 104. Then the one or more vias 104 may be filled by a barrier, for example a TaN barrier, and a seed layer, for example Cu, deposition followed by, for example, electro-chemical deposition (ECD) bottom-up filling, annealing and CMP.

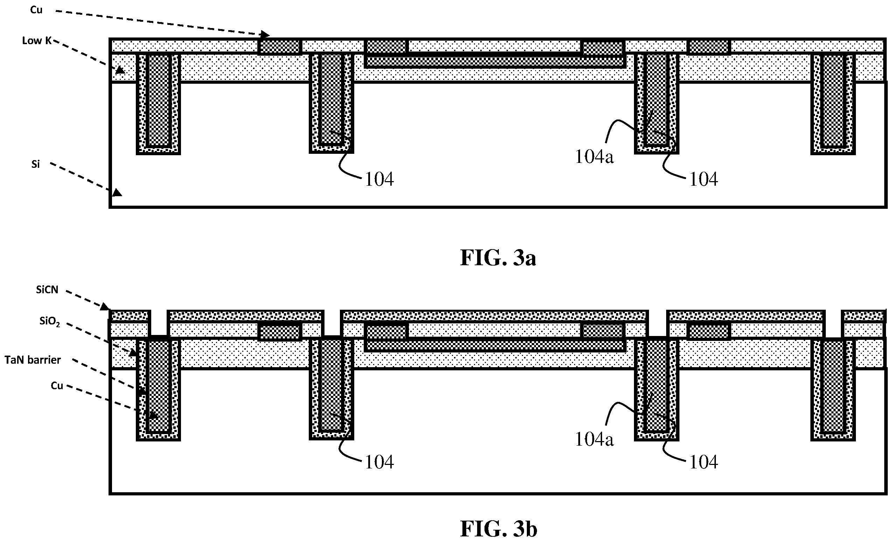

FIG. 3a shows a dielectric layer being added and patterned defining one or more drive electrodes for each contact switch 103a. A damascene process may then be performed to contact the electrode interconnects to the one or more drive electrodes for each contact switch 103a. The respective one or more drive electrodes may be surrounding the via 104a that will be switched on and off with the corresponding contact switch 103a and/or NEMS/MEMS structure after fabrication.

FIG. 3b shows a silicon carbonitride (SiCN) dielectric being deposited on top of the interposer section 101. Further, contacts to the vias 104 or TSVs 104 may be etched. A TSV contact opening may be fabricated.

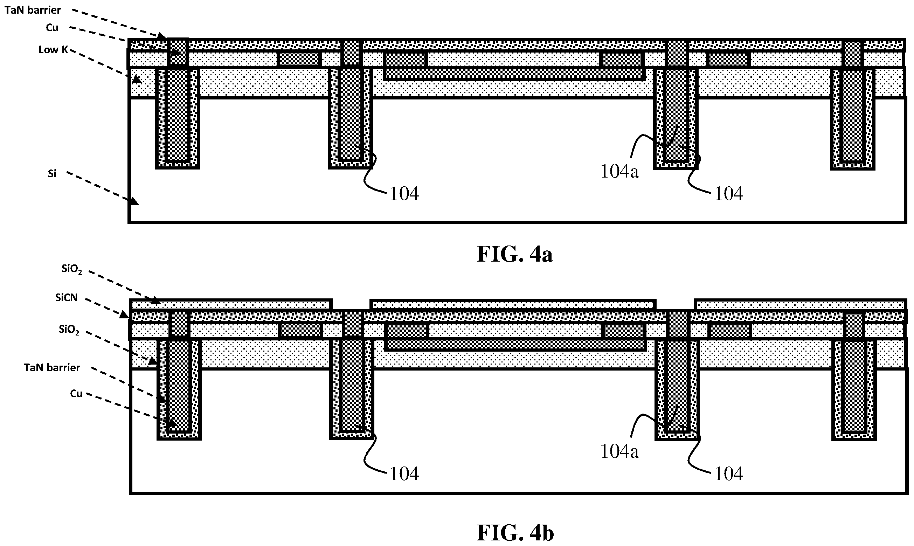

FIG. 4a shows the contacts to the vias 104 being filled with a damascene process, for example as described above and/or with Cu and a TaN barrier. No anneal may be performed. The CMP specifications at this step may be more strict in terms of planarity and Cu recess control in order to allow a hybrid bonding process.

FIG. 4b shows a silicon oxide layer being deposited, for example at low temperature, and patterned to create, for each contact switch 103a, an opening of the via 104a that is to be switched by the contact switch 103a. The silicon oxide layer may be 50 nm thick and may be deposited based on PECVD.

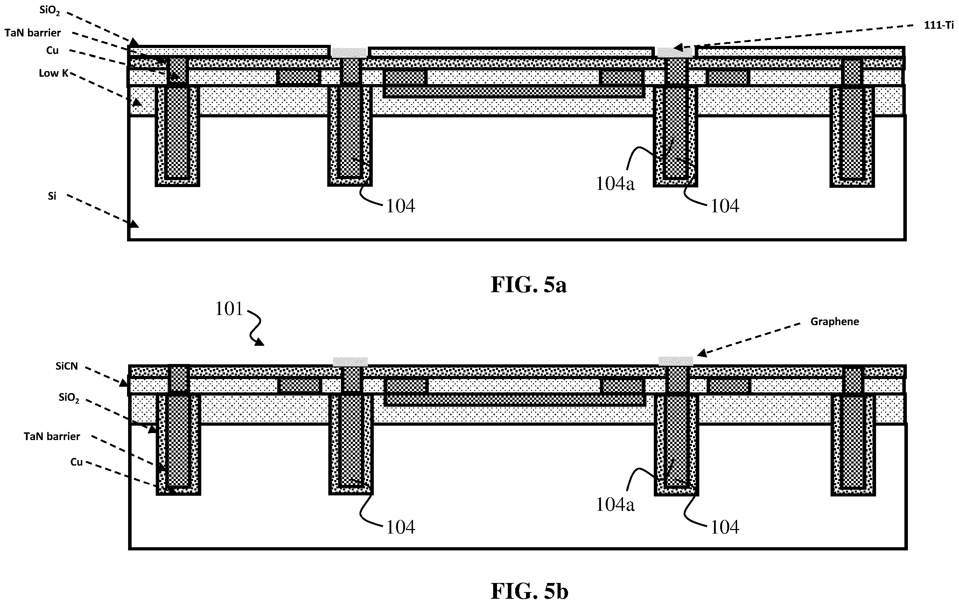

FIG. 5a shows a catalyst layer, for example, a 10nm catalyst layer, being deposited in the opening of the via 104a and/or patterned. The catalyst layer may be deposited by physical vapor deposition (PVD), evaporation, CVD or ALD. For example, a 111-oriented Ti catalyst layer allows to be dissolved layer on, whereas Ni, Cu, Pd, are metals that can be used to grow graphene. After metal patterning (lift-off, wet etching or dry etching) CVD growth may be performed followed by a short CMP step to clean the dielectric surface from carbon contamination.

FIG. 5b shows growing a graphene layer on top of the opening of the via 104a, for example by CVD. Further, a thin silicon oxide layer that may be deposited on top of the interposer section 101 may be removed, for example, with a vapor HF, wet dHF or other wet chemical treatment.

The catalyst layer below the graphene layer may be etched away at the same time if Ti is used, or remain untouched if other metals are used.

For the following description of the fabricating of the active section 102, a substrate of the active section 102 is considered to be at the bottom of the active section 102, wherein layers are provided on top, for example in an opposite direction than the bottom, of said substrate.

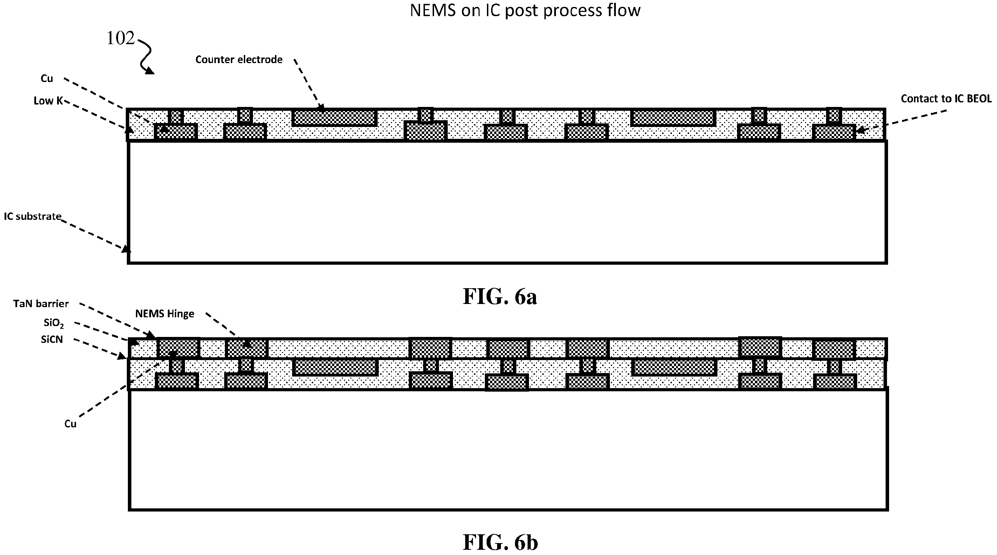

FIG. 6a shows an exemplary first step of the active section 102 process flow for fabricating the active section 102. The active section 102 may comprise the one or more contact switches 103. BEOL contacts, for example two layers of Cu, and/or one or more counter electrodes for each contact switch 103a may be defined by a conventional damascene process on the substrate of the active section 102, for example an integrated circuit (IC) substrate. The BEOL contacts and the one or more counter electrodes for each contact switch 103a may be comprised in a first layer.

FIG. 6b shows defining one or more first hinge parts or first contact switch 103a hinges, for example Cu contacts, for the one or more contact switches 103 by the deposition of a protective layer, for example SiCN, and/or one or more sacrificial sections, for example SiO₂, on top of the active section 102 based on a damascene process. The first hinge parts may be deposited on top of the protective layer and the one or more sacrificial sections may delimit the first hinge parts from the side. The one or more first hinge parts and the one or more sacrificial sections may form a second layer.

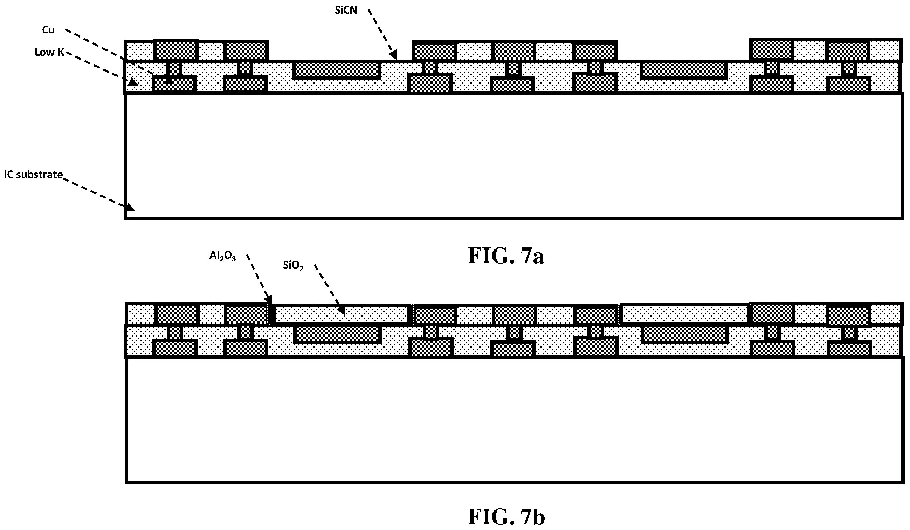

FIG. 7a shows etching a second cavity into the second layer, for example by etching the one or more sacrificial sections, around the one or more counter electrodes, wherein the etching may be stopped on the protective layer. The protective layer may be partially etched, fully etched, or not etched and may be a first protective layer.

FIG. 7b shows depositing a second protective layer, for example a SiCN layer, and/or replenishing the first protective layer to cover the bottom of the second cavity. Further, a protective material, for example an Al₂O₃ layer, may be deposited, for example by ALD or CVD, to cover the sidewalls of the second cavity. Further, a sacrificial material, for example SiO₂, may be deposited to fill or refill the second cavity. CMP may be performed and may be stopped on the protective layer. The protective layer may be the first protective layer or the second protective layer.

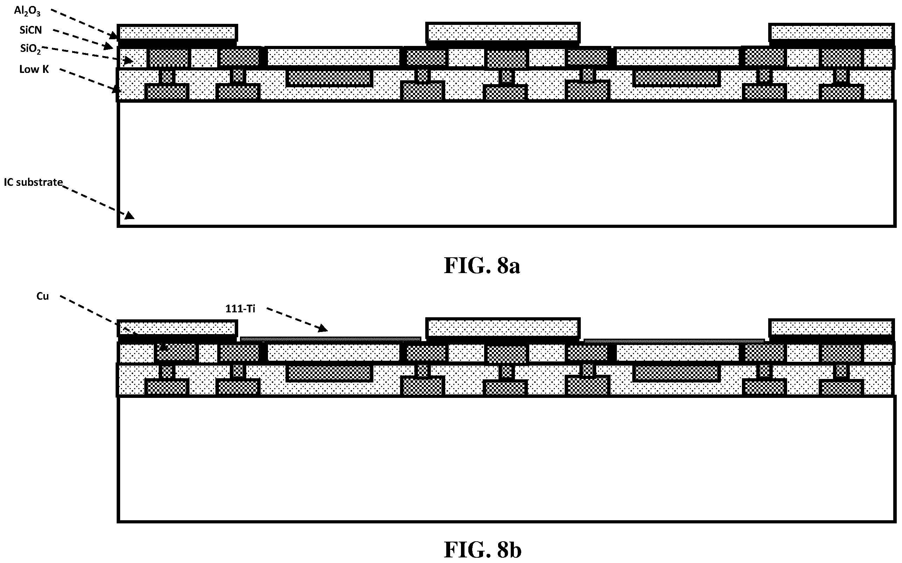

FIG. 8a shows depositing additional SiCN/Al₂O₃/SiO₂ layers and patterning said layers by plasma etching stopping on top of the second layer, for example on top of Cu contacts. Further, a dry etch of SiO₂-SiCN stopping on SiO₂ after a SiCN etch may be performed. Thus, the second layer may be exposed in the regions above the one or more counter electrodes for each contact switch 103a, which may form one or more first cavities or one or more contact switch 103a membrane cavities.

FIG. 8b shows depositing, for example by PVD, a sacrificial layer, for example a catalyst metal layer, in the one or more first cavities. Further, the sacrificial layer may be patterned. For example, the sacrificial layer may be a 111-oriented 10nm Ti layer.

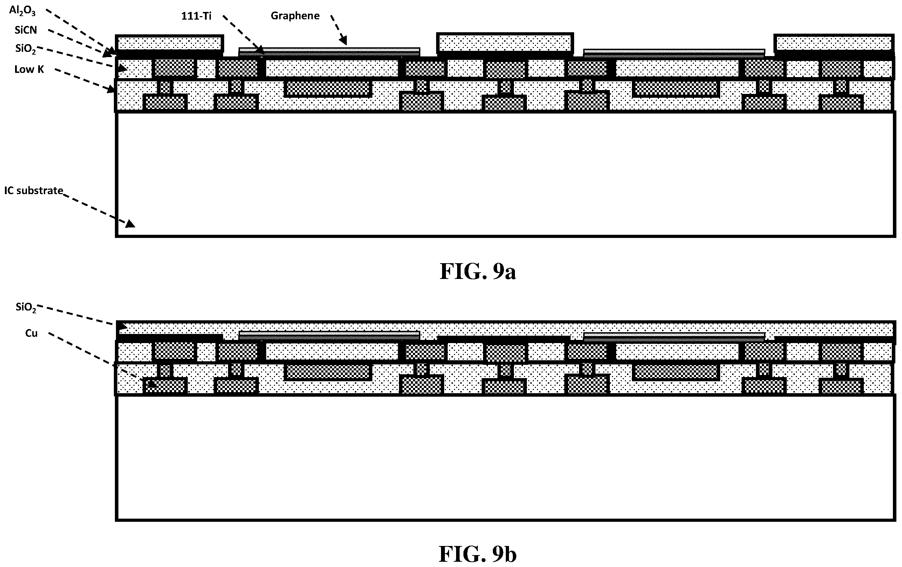

FIG. 9a shows growing, for each first cavity, a graphene membrane 105a on the sacrificial layer, for example by CVD. Further, a CMP may be performed to remove the carbon contaminant from the sacrificial material surface, for example the SiO₂ surface. The Graphene membrane 105a may be a graphene mono layer or a multiple layer.

FIG. 9b shows depositing an additional SiO₂ layer on the graphene membrane 105a, and/or planarizing the top of the active section 102 and/or the additional SiO₂ layer by CMP.

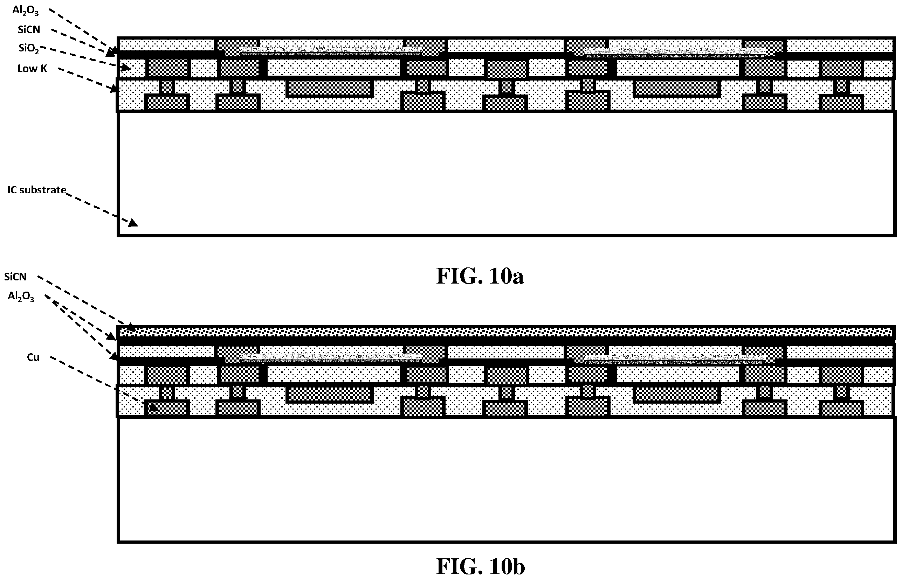

FIG. 10a shows performing a damascene process to finalize the contact switch 103a hinges. An opening, for example an oxide opening, may be created for the contact switch 103a hinges, for example for the second hinge parts. Said openings may be filled to form second hinge parts, wherein respectively a first hinge part and a second hinge part may form a hinge. Said openings may be filled with, for example TaNTa/Cu, and may be planarized by, for example CMP.

FIG. 10b shows depositing an Al₂O₃ layer with a bond dielectric on top, for example SiCN, on top of a layer comprising the second hinge parts and/or the additional SiO₂ layer.

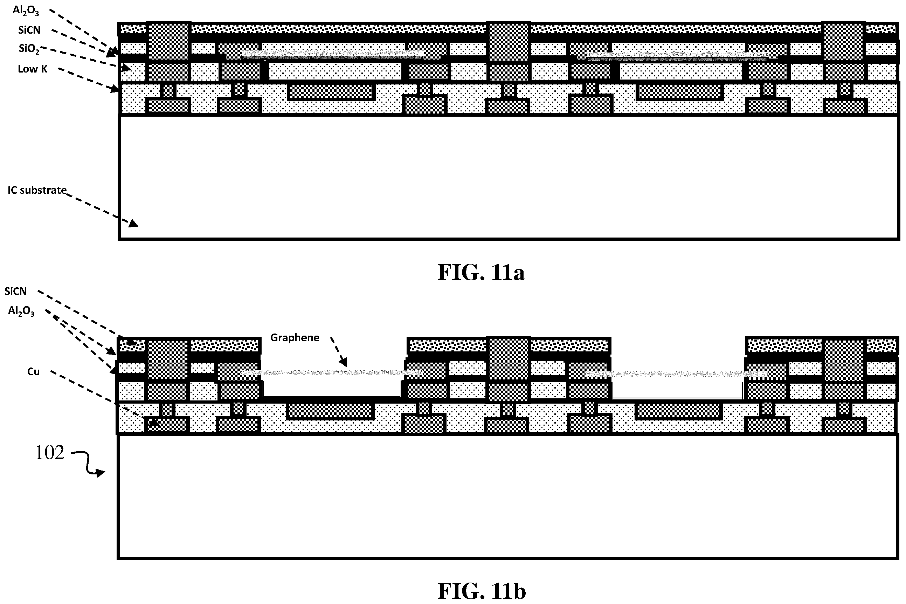

FIG. 11a shows forming bond pads by a damascene process. The bond pads may have constrains on dielectric flatness and Cu recess that are compatible with hybrid bonding.

FIG. 11b shows releasing the graphene membrane 105a for each contact switch 103a. The graphene membrane 105a may be released by removing and/or etching the material in an area on top of the one or more counter drive electrodes up to the protective layer. A Ti hard mask may be deposited and patterned and used to etch the SiCN and the Al₂O₃ layers, stopping at the additional SiO₂ layer. Then vapor HF may be used to release the graphene membrane 105a and etch the Ti hard mask. Wet chemistries may be followed by supercritical CO₂ drying to avoid the graphene membrane 105a to stick to the counter electrode, which may be positioned below the counter electrode.

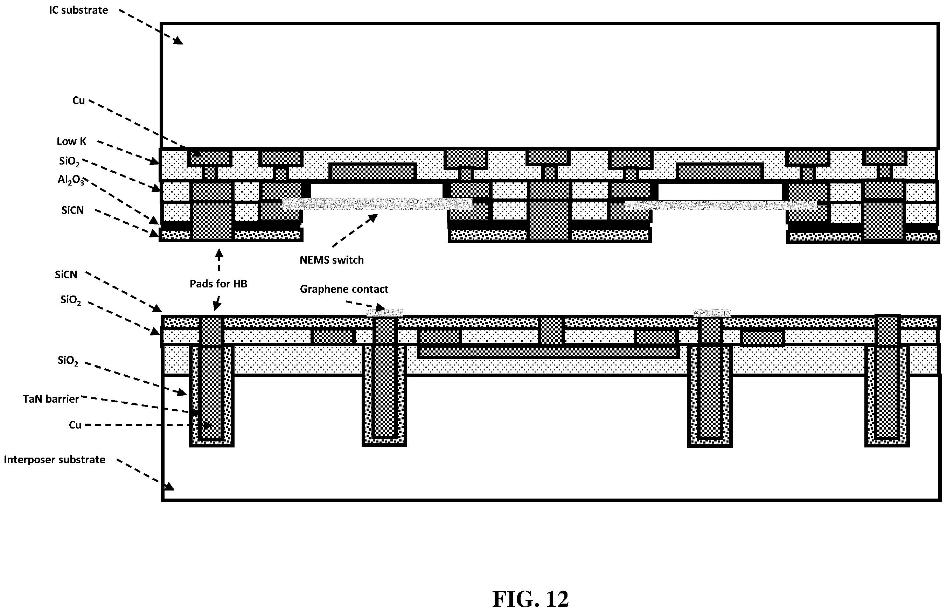

FIG. 12 shows bonding the active section 102 to the interposer section 101. The active section 102 and the interposer section 101 may be referred to as "wafers" respectively. Both wafers may be plasma activated and aligned in a wafer bonder. The two wafers may be put in contact for the hybrid bonding, for example at room temperature, followed by, for example, a 2 hours anneal to make the dielectric bonding stronger and allow diffusion, for example, Cu-Cu diffusion. It may be preferred to flush the bonding tool atmosphere with N₂ or Ar in order to avoid oxygen. This may allow to go for higher post bond anneal safely and ensure better yield for the Cu-Cu interconnects and therefore may relax the CMP requirements before bonding.

FIG. 12 shows bonding the top of the interposer section 101 to the top of the active section 102, for example based on pads for hybrid bonding (HB) comprised in both wafers. The active section 102 is shown flipped upside down such that the top of both wafers can be bonded to each other. The wafers may be bonded such that a respective via 104a of the interposer section 101 is positioned on top of each graphene membrane 105a, when considering that the interposer section 101 is positioned on top of the active section 102.

After bonding the interposer section 101 to the active section 102, only the reference frame of the active section 102 may be considered. For example, after bonding, the substrate of the interposer section 101 may be considered to be on top of the semiconductor device 100.

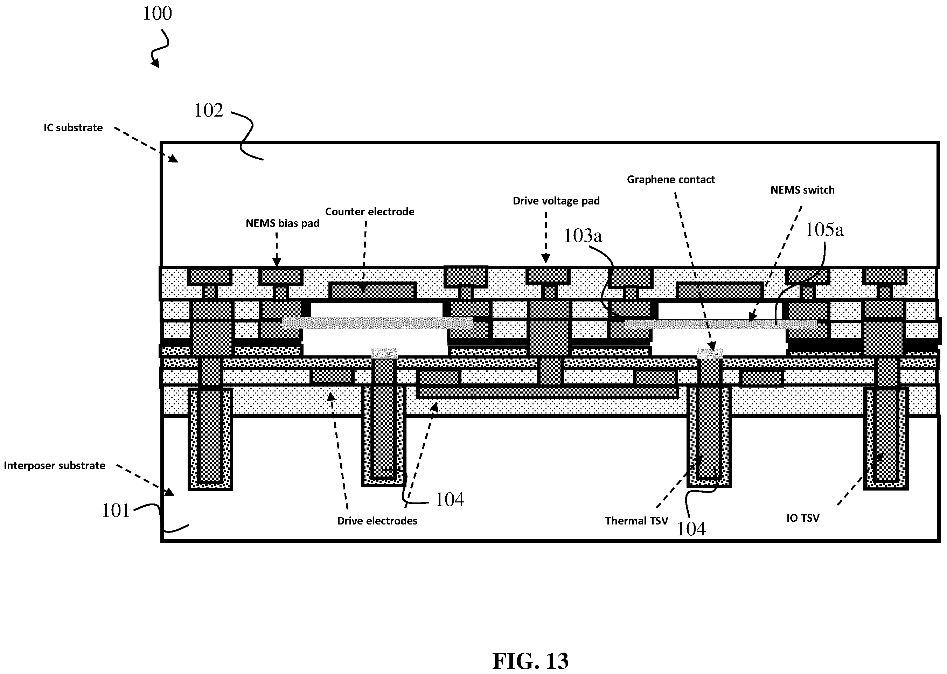

FIG. 13 shows an exemplary semiconductor device 100 according an embodiment of this disclosure. The exemplary semiconductor device 100 may be fabricated by bonding the active section 102 to the interposer section 101 as show in FIG. 12. The interposer section 101 may be considered to be on top of the active section 102. Thus, the semiconductor device 100 shown in FIG. 13 may be considered to be shown upside down.

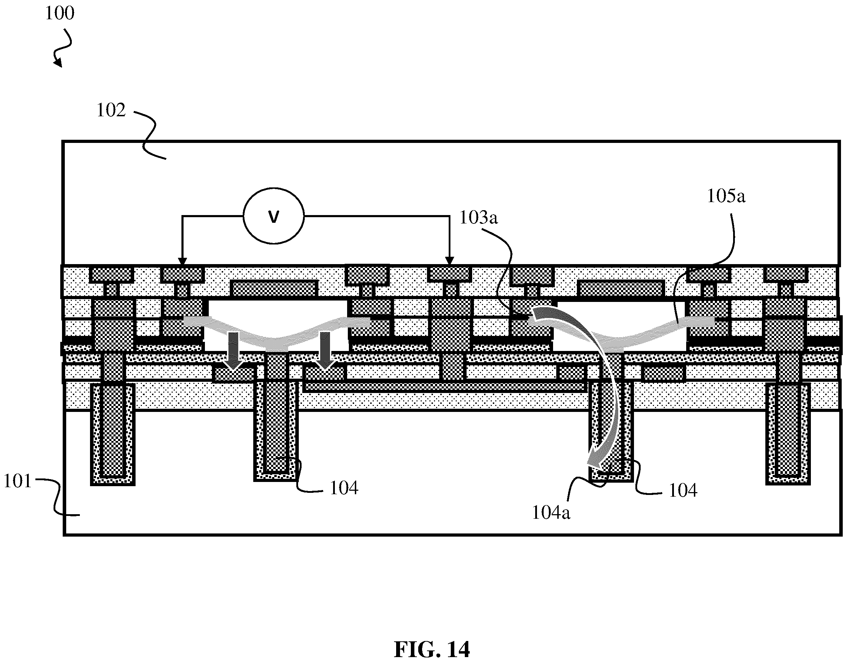

FIG. 14 shows applying a drive electrode bias. A voltage may be applied, for each contact switch 103a, between a NEMS/MEMS bias pad and the one or more drive electrodes, for example through a drive electrode pad. Each drive electrode pad may be electrically connected through the active section to a drive electrode interconnect and/or respective drive electrodes in the interposer section 101. FIG. 14 shows, for each contact switch 103a, the graphene membrane 105a being electrically attracted by the one or more drive electrodes in the interposer section 101 such that the graphene membrane 105a is thermally connected to the respective via 104a. Thus, heat and/or electron conduction through the via 104a can be used to cool the semiconductor device 100. The graphene membrane 105a may thermally connect to a graphene contact of the via 104a.

FIG. 14 shows applying a counter drive electrode bias. A voltage may be applied, for each contact switch 103a, between a NEMS/MEMS bias pad and the one or more counter drive electrodes, for example through a counter drive electrode pad. FIG. 14 shows, for each contact switch 103a, the graphene membrane 105a being electrically attracted by the one or more counter drive electrodes in the active section 102 such that the graphene membrane 105a is thermally disconnected from the respective via 104a. Thus, heat and/or electron conduction from the graphene membrane 105a through the via 104a is disrupted.

A high quality graphene membrane 105a, for example a graphene monolayer, may be grown and/or patterned according to an embodiment of this disclosure. Said method may be CMOS compatible. This process may be realized by first depositing an oxide and forming a first cavity in it as shown in FIG. 8a. Further, a sacrificial layer, for example a metal catalyst layer, may deposited and patterned in the first cavity as shown in FIG. 8b. The sacrificial layer may be a 111-oriented Ti layer but may also be a 111-Ni, Pt, Pd, or Cu layer. Further, deposition of graphene may be performed, for example based on CVD. The graphene membrane may form on top of the sacrificial layer. Amorphous carbon may be deposited on dielectric surfaces. Further, a CMP step may be performed to clean the oxide surface before a dHF may be performed to remove an oxide cavity if needed.

Fabricating the semiconductor device 100 may comprise integrating a freestanding graphene membrane 105a in-between the interposer section 101 and the active section 102, for example a hybrid-bonded active wafer, for example, as shown in FIG 13. This allows the semiconductor device 100, for example a CMOS chip, to actuate the contact switch 103a using the driving electrodes located in the interposer section 101 and counter drive electrodes located in the BEOL layer of the active section 102, for example in the BEOL of the CMOS wafer, or the opposite depending on the requirement for normally on or normally off type contact switches 103.

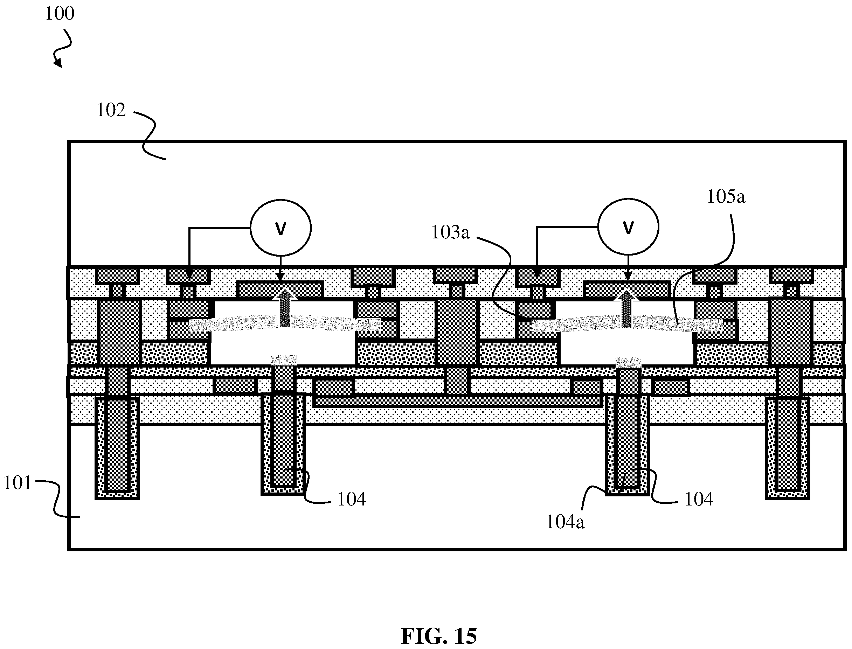

The one or more graphene based contact switches 103 may be used to thermally and/or electrically contact the one or more via structures 104 present in the interposer section 101 to allow power management of the semiconductor device 100 and/or the CMOS chip. The power management may comprise activating the power supplies of parts of a microprocessor if heavy computation is required. It may also comprise connecting additional thermal drains to dissipate heat generated by heavy computing tasks of semiconductor device 100 and/or the CMOS wafer. FIG. 14 shows applying a bias to the drive electrode and force the graphene membrane 105a to contact the via 104a. When the contact is not required anymore, the drive voltage can be set to the membrane potential and the counter electrode may be activated as shown in FIG. 15 to release the contact of the graphene membrane 105a to the via 104a.

Notably, in this disclosure, forming and/or providing a layer "on" another layer may mean growing/depositing these layers one upon the other. Thus, surfaces of these layers are in contact. Forming a layer "above" or "on top" another layer may mean that this layer is formed after the other layer, but there are formed one or more layers in between.

"Top" and "bottom", as used herein, are defined with respect to a "body-fixed" reference frame/coordinate system. For example, a reference frame that is fixed to a body rotates with said body in case the body is rotated, wherein a body may be the semiconductor device 100, the interposer section 101, and/or the active section 102.

Further, in this disclosure when referring to the active section 102, the substrate of the active section 102 may be considered to be on the bottom of the active section 102.

Further, in this disclosure when referring only to the interposer section 101, the substrate of the interposer section 101 may be considered to be on the bottom of the interposer section 101.

Further, in this disclosure when referring to the semiconductor device 100, the interposer section 101 may be considered to be on top of the active section 102.

Embodiments of this disclosure are applicable to high performance computing (HPC) chips that require heat dissipation and achieve high clock frequency workloads with limited power consumption. If a system requires to activate parts of its circuit when high a computing load is required or when an intense workload has heated up the structure, additional cooling can be connected to drain the heat faster.

Embodiments of this disclosure may be used in HPC, artificial intelligence (AI) chips manufacturing as well as for any high power dissipating structures integrating a high density of active devices. This can be part of the interposer supporting chip to chip interconnects, microfluidic cooling circuits and TSV. It can be integrated also in a 3D stacked chip in the BEOL of these chips to connect PDNs and IOS of these chips. Therefore it can be integrated in 3D DRAM chips or in high density memory banks for power management or repair functions (allow to disconnect or connect part of the chip area).

Embodiments of this disclosure may be adapted to any application where graphene is required to be deposited and patterned, for example, in optical modulators or chemical sensor. The graphene membrane 105a may be deposited by layer transfer and/or patterned after dielectric encapsulation. However the quality of the graphene obtained by layer transfer may be lower. Switchable vias 104, for examples TSVs, could be implemented with a solid state transistor to disconnect the parasitic components from the system but with the drawback of mechanical stress field that will impact the floor plan of the design by the addition of keep-out-zones (KOZ).

The controller 106 may be a processor 106.

Generally, the processor 106 may be configured to perform, conduct or initiate the various operations of the semiconductor device 100 described herein. The processor 106 may comprise hardware and/or may be controlled by software. The hardware may comprise analog circuitry or digital circuitry, or both analog and digital circuitry. The digital circuitry may comprise components such as application-specific integrated circuits (ASICs), field-programmable arrays (FPGAs), digital signal processors (DSPs), or multi-purpose processors. The semiconductor device 100 may further comprise memory circuitry, which stores one or more instruction(s) that can be executed by the processor 106, in particular under control of the software. For instance, the memory circuitry may comprise a non-transitory storage medium storing executable software code which, when executed by the processor 106, causes the various operations of the semiconductor device 100 to be performed. In one embodiment, the semiconductor device 100 may comprises one or more processors 106 and a non-transitory memory connected to the one or more processors 106. The non-transitory memory may carry executable program code which, when executed by the one or more processors 106, causes the semiconductor device 100 to perform, conduct or initiate the operations or methods described herein.

FIG. 14 shows a method 200 according to an embodiment of this disclosure. The method 200 may be for fabricating the semiconductor device 100. The method 200 comprises a step 201 of providing a substrate for an interposer section 101. Further, the method 200 comprises a step 202 of etching one or more trenches into the substrate for the interposer section 101. Further, the method 200 comprises a step 203 of filling the one or more trenches to form one or more vias 104. Further, the method 200 comprises a step 204 of providing a substrate for an active section 102. Further, the method 200 comprises a step 205 of providing one or more graphene membranes on the active section 102 or the interposer section 101. Further, the method 200 comprises a step 206 of forming one or more NEMS/MEMS contact switches 103 based on the one or more graphene membranes. Further, the method 200 comprises a step 207 of bonding the interposer section 101 to the active section 102, such that, for each contact switch 103a, the graphene membrane 105a of the contact switch 103a is thermally connected to the respective via 104a in a first switching state and is thermally disconnected from the respective via 104a in a second switching state.

Generally, each contact switch 103a of the one or more contact switches 103 is arranged between the interposer section 101 and the active section 102 and adjacent to a respective via 104a of the one or more vias 104 of the interposer section 101. Each contact switch 103a can be switched between the first switching state and the second switching state.

## Claims

1. A semiconductor device (100) comprising
an active section (102), an interposer section (101) arranged on the active section (102), and one or more nanoelectromechanical systems or microelectromechanical systems, NEMS/MEMS, contact switches (103) arranged between the interposer section (101) and the active section (102),
wherein the interposer section (101) comprises one or more vias (104),
wherein the active section (102) comprises at least a part of each contact switch (103a) of the one or more contact switches (103),
wherein each contact switch (103a) of the one or more contact switches (103) comprises a graphene membrane (105a), and
wherein each contact switch (103a) of the one or more contact switches (103) is configured to be switched between
a first switching state, in which the graphene membrane (105a) of the contact switch (103a) is thermally connected to a respective via (104a) of the one or more vias (104) of the interposer section (101), and
a second switching stage, in which the graphene membrane (105a) of the contact switch (103a) is thermally disconnected from the respective via (104a) of the one or more vias (104) of the interposer section (101).

2. The semiconductor device (100) according to claim 1, further comprising a controller (106) configured to selectively control one contact switch (103a), or some contact switches (103), or all contact switches (103) to the first switching state or the second switching state.

3. The semiconductor device (100) according to any of the preceding claims,
wherein the graphene membrane (105a) of each contact switch (103a) is a freestanding graphene membrane (105a) if the graphene membrane (105a) is not thermally connected to the respective via (104a).

4. The semiconductor device (100) according to any of the preceding claims,
wherein, for each contact switch (103a), the graphene membrane (105a) is part of an actuator of the contact switch (103a).

5. The semiconductor device (100) according to any of the preceding claims,
wherein each contact switch (103a) comprises two hinges, wherein each hinge comprises a first hinge part and a second hinge part, and wherein at least a part of the graphene membrane (105a) of that contact switch (103a) is sandwiched between the second hinge part and the first hinge part.

6. The semiconductor device (100) according to any of the preceding claims,
wherein the active section (102) comprises the graphene membranes of the one or more contact switches (103), and/or
wherein each graphene membrane (105a) of the one or more contact switches (103) is directly attached to the active section (102).

7. The semiconductor device (100) according to any of the preceding claims,
wherein each via of the one or more vias (104) is directly attached to the interposer section (101).

8. The semiconductor device (100) according to any of the preceding claims,
wherein, for each contact switch (103a), the respective via (104a) is attached to the graphene membrane (105a) if the graphene membrane (105a) is thermally connected to the respective via (104a).

9. The semiconductor device (100) according to any of the preceding claims,
wherein, for each contact switch (103a), the interposer section (101) comprises one or more drive electrodes and the active section (102) comprises one or more counter drive electrodes, or
wherein, for each contact switch (103a), the interposer section (101) comprises one or more counter drive electrodes and the active section (102) comprises one or more drive electrodes.

10. The semiconductor device (100) according to any of the preceding claims,
wherein the active section (102) comprises one or more drive voltage pads, wherein each drive voltage pad is electrically connected to the one or more drive electrodes of at least one contact switch (103a).

11. The semiconductor device (100) according to any of the preceding claims,
wherein the active section (102) comprises, for each contact switch (103a), at least one NEMS/MEMS bias pad that is electrically connected to the graphene membrane (105a) of the contact switch (103a).

12. The semiconductor device (100) according to any of the preceding claims,
wherein, for each contact switch (103a), the one or more drive electrodes are configured to electrically attract the graphene membrane (105a) to thermally connect the graphene membrane (105a) to the respective via (104a), and
wherein, for each contact switch (103a), the one or more counter drive electrodes are configured to electrically attract the graphene membranes to thermally disconnect the graphene membrane (105a) from the respective via (104a).

13. The semiconductor device (100) according to any of the preceding claims,
wherein the active section (102) is hybrid bonded to the interposer section (101) and/or
wherein the active section (102) comprises one or more pads for hybrid bonding and the interposer section (101) comprises one or more pads for hybrid bonding.

14. The semiconductor device (100) according to any of the preceding claims,
wherein the one or more contact switches (103) form at least a part of the interface of the interposer section (101) and the active section (102).

15. The semiconductor device (100) according to any of the preceding claims,
wherein, for each contact switch (103a), the respective via (104a) comprises a graphene contact for thermally connecting to the graphene membrane (105a) of the contact switch (103a).

16. The semiconductor device (100) according to any of the preceding claims,
wherein, for each contact switch (103a), the one or more drive electrodes are surrounding the respective via (104a) from a top view of the semiconductor device (100), and/or wherein the respective via (104a) is electrically disconnected from the one or more drive electrodes.

17. A method (200) for fabricating a semiconductor device (100), wherein the method (200) comprises:
providing (201) a substrate for an interposer section (101),
etching (202) one or more trenches into the substrate for the interposer section (101),
filling (203) the one or more trenches to form one or more vias (104),
providing (204) a substrate for an active section (102),
providing (205) one or more graphene membranes on the active section (102) or the interposer section (101),
forming (206) one or more nanoelectromechanical systems or microelectromechanical systems, NEMS/MEMS, contact switches (103) based on the one or more graphene membranes, wherein each contact switch (103a) can be switched between a first switching state and a second switching state,
bonding (207) the interposer section (101) to the active section (102), wherein each contact switch (103a) of the one or more contact switches (103) is arranged between the interposer section (101) and the active section (102) and adjacent to a respective via (104a) of the one or more vias (104) of the interposer section (101), such that the graphene membrane (105a) of the contact switch (103a) is thermally connected to the respective via (104a) in the first switching state and is thermally disconnected from the respective via (104a) in the second switching state.

18. The method (200) according to claim 17, wherein the method (200) further comprises:
providing a first layer comprising one or more first electrodes on top of the substrate for the active section (102),
providing a second layer on top of the first layer comprising one or more sacrificial sections and one or more first hinge parts for the one or more contact switches (103),
providing a third layer on top of the second layer, wherein the third layer comprises, for each first electrode, a first cavity,
providing, for each first electrode, into the first cavity a sacrificial layer to cover at least a part of the area on top of each first hinge part of two adjacent first hinge parts and to cover the area on top of the first electrode,
growing, for each first electrode, a graphene membrane (105a) on top of the sacrificial layer to cover at least a part of the area on top of each first hinge part of the two adjacent first hinge parts and to cover the area on top of the first electrode,
depositing, for each first electrode and for each first hinge part of the two adjacent first hinge parts, a second hinge part on top of the first hinge part into the third layer to form a hinge, wherein at least a part of the graphene membrane (105a) is sandwiched between the second hinge part and the first hinge part, and
releasing, for each first electrode, the graphene membrane (105a) based on removing the sacrificial layer and a respective sacrificial section of the one or more sacrificial sections.

19. The method (200) according to claim 18, wherein the method (200) further comprises:
etching, for each first electrode, a second cavity into the respective sacrificial section of the second layer in an area on top of the first electrode and between two adjacent first hinge parts of the one or more first hinge parts,
providing, for each first electrode, a protective material on the side walls of the second cavity towards the two adjacent first hinge parts,
providing, for each first electrode, a sacrificial material into the second cavity for filling the second cavity and reforming the respective sacrificial section.

20. The method (200) according to claim 18 or 19, wherein the method (200) further comprises:
providing a protective layer on top of the first layer, and
providing the second layer comprising the one or more sacrificial sections and the one or more first hinge parts on top of the protective layer.

21. The method (200) according to one of the claims 18 to 20, wherein the one or more first electrodes are counter drive electrodes or drive electrodes.

22. The method (200) according to one of the claims 17 to 21, wherein the method (200) further comprises
bonding the active section (102) to the interposer section (101) based on hybrid bonding.

## Patentansprüche

1. Halbleitervorrichtung (100), umfassend
einen aktiven Abschnitt (102), einen Interposer-Abschnitt (101), der auf dem aktiven Abschnitt (102) angeordnet ist, und einen oder mehrere Kontaktschalter (103) nano- oder mikroelektromechanischer Systeme, NEMS/MEMS, die zwischen dem Interposer-Abschnitt (101) und dem aktiven Abschnitt (102) angeordnet sind,
wobei der Interposer-Abschnitt (101) ein oder mehrere Vias (104) umfasst,
wobei der aktive Abschnitt (102) mindestens einen Teil eines jeden Kontaktschalters (103a) des einen oder der mehreren Kontaktschalter (103) umfasst,
wobei jeder Kontaktschalter (103a) des einen oder der mehreren Kontaktschalter (103) eine Graphen-Membran (105a) umfasst und wobei jeder Kontaktschalter (103a) des einen oder der mehreren Kontaktschalter (103) dazu konfiguriert ist, geschaltet zu werden zwischen
einem ersten Schaltzustand, in dem die Graphen-Membran (105a) des Kontaktschalters (103a) thermisch mit einem jeweiligen Via (104a) des einen oder der mehreren Vias (104) des Interposer-Abschnitts (101) verbunden ist, und
einem zweiten Schaltzustand, in dem die Graphen-Membran (105a) des Kontaktschalters (103a) thermisch von dem jeweiligen Via (104a) des einen oder der mehreren Vias (104) des Interposer-Abschnitts (101) getrennt ist.

2. Halbleitervorrichtung (100) nach Anspruch 1, ferner umfassend eine Steuerung (106), die dazu konfiguriert ist, einen Kontaktschalter (103a) oder einige Kontaktschalter (103) oder alle Kontaktschalter (103) selektiv in den ersten Schaltzustand oder in den zweiten Schaltzustand zu steuern.

3. Halbleitervorrichtung (100) nach einem der vorhergehenden Ansprüche,
wobei die Graphen-Membran (105a) eines jeden Kontaktschalters (103a) eine freistehende Graphen-Membran (105a) ist, wenn die Graphen-Membran (105a) nicht thermisch mit dem jeweiligen Via (104a) verbunden ist.

4. Halbleitervorrichtung (100) nach einem der vorhergehenden Ansprüche,
wobei für jeden Kontaktschalter (103a) die Graphen-Membran (105a) Teil eines Aktors des Kontaktschalters (103a) ist.

5. Halbleitervorrichtung (100) nach einem der vorhergehenden Ansprüche,
wobei jeder Kontaktschalter (103a) zwei Scharniere umfasst, wobei jedes Scharnier ein erstes Scharnierteil und ein zweites Scharnierteil umfasst und wobei mindestens ein Teil der Graphen-Membran (105a) dieses Kontaktschalters (103a) zwischen dem zweiten Scharnierteil und dem ersten Scharnierteil eingeschlossen ist.

6. Halbleitervorrichtung (100) nach einem der vorhergehenden Ansprüche,
wobei der aktive Abschnitt (102) die Graphen-Membranen des einen oder der mehreren Kontaktschalter (103) umfasst und/oder
wobei jede Graphen-Membran (105a) des einen oder der mehreren Kontaktschalter (103) direkt an dem aktiven Abschnitt (102) angebracht ist.

7. Halbleitervorrichtung (100) nach einem der vorhergehenden Ansprüche,
wobei jedes Via des einen oder der mehreren Vias (104) direkt an dem Interposer-Abschnitt (101) angebracht ist.

8. Halbleitervorrichtung (100) nach einem der vorhergehenden Ansprüche,
wobei für jeden Kontaktschalter (103a) der jeweilige Via (104a) an der Graphen-Membran (105a) angebracht ist, wenn die Graphen-Membran (105a) thermisch mit dem jeweiligen Via (104a) verbunden ist.

9. Halbleitervorrichtung (100) nach einem der vorhergehenden Ansprüche,
wobei für jeden Kontaktschalter (103a) der Interposer-Abschnitt (101) eine oder mehrere Antriebselektroden umfasst und der aktive Abschnitt (102) eine oder mehrere Gegentriebselektroden umfasst oder
wobei für jeden Kontaktschalter (103a) der Interposer-Abschnitt (101) eine oder mehrere Gegentriebselektroden umfasst und der aktive Abschnitt (102) eine oder mehrere Antriebselektroden umfasst.

10. Halbleitervorrichtung (100) nach einem der vorhergehenden Ansprüche,
wobei der aktive Abschnitt (102) ein oder mehrere Antriebsspannungspads umfasst, wobei jedes Antriebsspannungspad mit der einen oder den mehreren Antriebselektroden mindestens eines Kontaktschalters (103a) elektrisch verbunden ist.

11. Halbleitervorrichtung (100) nach einem der vorhergehenden Ansprüche,
wobei der aktive Abschnitt (102) für jeden Kontaktschalter (103a) mindestens ein NEMS/MEMS-Bias-Pad umfasst, das elektrisch mit der Graphen-Membran (105a) des Kontaktschalters (103a) verbunden ist.

12. Halbleitervorrichtung (100) nach einem der vorhergehenden Ansprüche,
wobei für jeden Kontaktschalter (103a) die eine oder die mehreren Antriebselektroden dazu konfiguriert sind, die Graphen-Membran (105a) elektrisch anzuziehen, um die Graphen-Membran (105a) mit dem jeweiligen Via (104a) thermisch zu verbinden, und wobei für jeden Kontaktschalter (103a) die eine oder die mehreren Gegentriebselektroden dazu konfiguriert sind, die Graphen-Membranen elektrisch anzuziehen, um die Graphen-Membran (105a) von dem jeweiligen Via (104a) thermisch zu trennen.

13. Halbleitervorrichtung (100) nach einem der vorhergehenden Ansprüche,
wobei der aktive Abschnitt (102) mit dem Interposer-Abschnitt (101) hybridgebondet ist und/oder
wobei der aktive Abschnitt (102) ein oder mehrere Pads zum Hybridbonden umfasst und der Interposer-Abschnitt (101) ein oder mehrere Pads zum Hybridbonden umfasst.

14. Halbleitervorrichtung (100) nach einem der vorhergehenden Ansprüche,
wobei der eine oder die mehreren Kontaktschalter (103) mindestens einen Teil der Schnittstelle des Interposer-Abschnitts (101) und des aktiven Abschnitts (102) bilden.

15. Halbleitervorrichtung (100) nach einem der vorhergehenden Ansprüche,
wobei für jeden Kontaktschalter (103a) das jeweilige Via (104a) einen Graphen-Kontakt zum thermischen Verbinden mit der Graphen-Membran (105a) des Kontaktschalters (103a) umfasst.

16. Halbleitervorrichtung (100) nach einem der vorhergehenden Ansprüche,
wobei für jeden Kontaktschalter (103a) die eine oder die mehreren Antriebselektroden das jeweilige Via (104a) bei einem Blick von oben auf die Halbleitervorrichtung (100) umgeben und/oder wobei das jeweilige Via (104a) von der einen oder den mehreren Antriebselektroden elektrisch getrennt ist.

17. Verfahren (200) zum Herstellen einer Halbleitervorrichtung (100), wobei das Verfahren (200) Folgendes umfasst:
Bereitstellen (201) eines Substrats für einen Interposer-Abschnitt (101),
Ätzen (202) eines oder mehrerer Gräben in das Substrat für den Interposer-Abschnitt (101),
Auffüllen (203) des einen oder der mehreren Gräben, um ein oder mehrere Vias (104) zu bilden,
Bereitstellen (204) eines Substrats für einen aktiven Abschnitt (102),
Bereitstellen (205) einer oder mehrerer Graphen-Membranen auf dem aktiven Abschnitt (102) oder auf dem Interposer-Abschnitt (101),
Bilden (206) eines oder mehrerer Kontaktschalter (103) nanoelektromechanischer Systeme oder mikroelektromechanischer Systeme, NEMS/MEMS, basierend auf der einen oder den mehreren Graphen-Membranen, wobei jeder Kontaktschalter (103a) zwischen einem ersten Schaltzustand und einem zweiten Schaltzustand schaltbar ist,
Bonden (207) des Interposer-Abschnitts (101) mit dem aktiven Abschnitt (102), wobei jeder Kontaktschalter (103a) des einen oder der mehreren Kontaktschalter (103) zwischen dem Interposer-Abschnitt (101) und dem aktiven Abschnitt (102) und benachbart zu einem jeweiligen Via (104a) des einen oder der mehreren Vias (104) des Interposer-Abschnitts (101) angeordnet ist, sodass die Graphen-Membran (105a) des Kontaktschalters (103a) im ersten Schaltzustand mit dem jeweiligen Via (104a) thermisch verbunden ist und im zweiten Schaltzustand von dem jeweiligen Via (104a) thermisch getrennt ist.

18. Verfahren (200) nach Anspruch 17, wobei das Verfahren (200) ferner Folgendes umfasst:
Bereitstellen einer ersten Schicht, umfassend eine oder mehrere erste Elektroden auf der Oberseite des Substrats für den aktiven Abschnitt (102),
Bereitstellen einer zweiten Schicht auf der Oberseite der ersten Schicht, umfassend einen oder mehrere Opferabschnitte und ein oder mehrere erste Scharnierteile für den einen oder die mehreren Kontaktschalter (103),
Bereitstellen einer dritten Schicht auf der Oberseite der zweiten Schicht, wobei die dritte Schicht für jede erste Elektrode einen ersten Hohlraum umfasst,
Bereitstellen, für jede erste Elektrode in den ersten Hohlraum, einer Opferschicht, um mindestens einen Teil der Fläche auf der Oberseite eines jeden ersten Scharnierteils zweier benachbarter erster Scharnierteile abzudecken und die Fläche auf der Oberseite der ersten Elektrode abzudecken,
Erstellen, für jede erste Elektrode, einer Graphen-Membran (105a) auf der Oberseite der Opferschicht, um mindestens einen Teil der Fläche auf der Oberseite eines jeden ersten Scharnierteils der zwei benachbarten ersten Scharnierteile abzudecken und um die Fläche auf der Oberseite der ersten Elektrode abzudecken,
Abscheiden, für jede erste Elektrode und für jedes erste Scharnierteil der zwei benachbarten ersten Scharnierteile, eines zweiten Scharnierteils auf der Oberseite des ersten Scharnierteils in die dritte Schicht, um ein Scharnier zu bilden, wobei mindestens ein Teil der Graphen-Membran (105a) zwischen dem zweiten Scharnierteil und dem ersten Scharnierteil eingeschlossen ist, und
Freigeben, für jede erste Elektrode, der Graphen-Membran (105a) basierend auf Entfernen der Opferschicht und eines jeweiligen Opferabschnitts des einen oder der mehreren Opferabschnitte.

19. Verfahren (200) nach Anspruch 18, wobei das Verfahren (200) ferner Folgendes umfasst:
Ätzen, für jede erste Elektrode, eines zweiten Hohlraums in den jeweiligen Opferabschnitt der zweiten Schicht in eine Fläche auf der Oberseite der ersten Elektrode und zwischen zwei benachbarten ersten Scharnierteilen des einen oder der mehreren ersten Scharnierteile,
Bereitstellen, für jede erste Elektrode, eines Schutzmaterials an den Seitenwänden des zweiten Hohlraums in Richtung der zwei benachbarten ersten Scharnierteile,
Bereitstellen, für jede erste Elektrode, eines Opfermaterials in den zweiten Hohlraum zum Auffüllen des zweiten Hohlraums und Neubilden des jeweiligen Opferabschnitts.

20. Verfahren (200) nach Anspruch 18 oder 19, wobei das Verfahren (200) ferner Folgendes umfasst:
Bereitstellen einer Schutzschicht auf der Oberseite der ersten Schicht und
Bereitstellen der zweiten Schicht, umfassend den einen oder die mehreren Opferabschnitte und das eine oder die mehreren ersten Scharnierteile auf der Oberseite der Schutzschicht.

21. Verfahren (200) nach einem der Ansprüche 18 bis 20, wobei die eine oder die mehreren ersten Elektroden Gegentriebselektroden oder Antriebselektroden sind.

22. Verfahren (200) nach einem der Ansprüche 17 bis 21, wobei das Verfahren (200) ferner Folgendes umfasst:
Bonden des aktiven Abschnitts (102) mit dem Interposer-Abschnitt (101) basierend auf Hybridbonden.

## Revendications

1. Dispositif à semi-conducteur (100) comprenant une section active (102), une section d'interposeur (101) agencée sur la section active (102), et un ou plusieurs commutateurs de contact (103) de systèmes nano-électromécaniques ou micro-électromécaniques, NEMS/MEMS, agencés entre la section d'interposeur (101) et la section active (102),
dans lequel la section d'interposeur (101) comprend un ou plusieurs trous d'interconnexion (104),
dans lequel la section active (102) comprend au moins une partie de chaque commutateur de contact (103a) des un ou plusieurs commutateurs de contact (103),
dans lequel chaque commutateur de contact (103a) des un ou plusieurs commutateurs de contact (103) comprend une membrane en graphène (105a), et
dans lequel chaque commutateur de contact (103a) des un ou plusieurs commutateurs de contact (103) est configuré pour être commuté entre
un premier état de commutation, dans lequel la membrane en graphène (105a) du commutateur de contact (103a) est connectée thermiquement à un trou d'interconnexion (104a) respectif des un ou plusieurs trous d'interconnexion (104) de la section d'interposeur (101), et
un second état de commutation, dans lequel la membrane en graphène (105a) du commutateur de contact (103a) est déconnectée thermiquement du trou d'interconnexion (104a) respectif des un ou plusieurs trous d'interconnexion (104) de la section d'interposeur (101).

2. Dispositif à semi-conducteur (100) selon la revendication 1, comprenant également un dispositif de commande (106) configuré pour commander sélectivement un commutateur de contact (103a), ou certains commutateurs de contact (103), ou tous les commutateurs de contact (103) dans le premier état de commutation ou le second état de commutation.

3. Dispositif à semi-conducteur (100) selon l'une quelconque des revendications précédentes,
dans lequel la membrane en graphène (105a) de chaque commutateur de contact (103a) est une membrane en graphène autonome (105a) si la membrane en graphène (105a) n'est pas connectée thermiquement au trou d'interconnexion (104a) respectif.

4. Dispositif à semi-conducteur (100) selon l'une quelconque des revendications précédentes,
dans lequel, pour chaque commutateur de contact (103a), la membrane en graphène (105a) fait partie d'un actionneur du commutateur de contact (103a).

5. Dispositif à semi-conducteur (100) selon l'une quelconque des revendications précédentes,
dans lequel chaque commutateur de contact (103a) comprend deux charnières, dans lequel chaque charnière comprend une première partie de charnière et une seconde partie de charnière, et dans lequel au moins une partie de la membrane en graphène (105a) de ce commutateur de contact (103a) est prise en tenaille entre la seconde partie de charnière et la première partie de charnière.

6. Dispositif à semi-conducteur (100) selon l'une quelconque des revendications précédentes,
dans lequel la section active (102) comprend les membranes en graphène des un ou plusieurs commutateurs de contact (103), et/ou
dans lequel chaque membrane en graphène (105a) des un ou
plusieurs commutateurs de contact (103) est directement fixée à la section active (102).

7. Dispositif à semi-conducteur (100) selon l'une quelconque des revendications précédentes,
dans lequel chaque trou d'interconnexion des un ou plusieurs trous d'interconnexion (104) est directement fixé à la section d'interposeur (101).

8. Dispositif à semi-conducteur (100) selon l'une quelconque des revendications précédentes,
dans lequel, pour chaque commutateur de contact (103a), le trou d'interconnexion (104a) respectif est fixé à la membrane en graphène (105a) si la membrane en graphène (105a) est connectée thermiquement au trou d'interconnexion (104a) respectif.

9. Dispositif à semi-conducteur (100) selon l'une quelconque des revendications précédentes,
dans lequel pour chaque commutateur de contact (103a), la section d'interposeur (101) comprend une ou plusieurs électrodes d'attaque et la section active (102) comprend une ou plusieurs électrodes de contre-attaque, ou
dans lequel, pour chaque commutateur de contact (103a), la section d'interposeur (101) comprend une ou plusieurs électrodes de contre-attaque et la section active (102) comprend une ou plusieurs électrodes d'attaque.

10. Dispositif à semi-conducteur (100) selon l'une quelconque des revendications précédentes,
dans lequel la section active (102) comprend un ou plusieurs plots de tension d'attaque, dans lequel chaque plot de tension d'attaque est relié électriquement aux une ou plusieurs électrodes d'attaque d'au moins un commutateur de contact (103a).

11. Dispositif à semi-conducteur (100) selon l'une quelconque des revendications précédentes,
dans lequel la section active (102) comprend, pour chaque commutateur de contact (103a), au moins un plot de polarisation NEMS/MEMS qui est relié électriquement à la membrane en graphène (105a) du commutateur de contact (103a).

12. Dispositif à semi-conducteur (100) selon l'une quelconque des revendications précédentes,
dans lequel, pour chaque commutateur de contact (103a), les une ou plusieurs électrodes d'attaque sont configurées pour attirer électriquement la membrane en graphène (105a) pour connecter thermiquement la membrane en graphène (105a) au trou d'interconnexion (104a) respectif, et
dans lequel, pour chaque commutateur de contact (103a), les une ou plusieurs électrodes de contre-attaque sont configurées pour attirer électriquement les membranes en graphène pour déconnecter thermiquement la membrane en graphène (105a) du trou d'interconnexion (104a) respectif.

13. Dispositif à semi-conducteur (100) selon l'une quelconque des revendications précédentes,
dans lequel la section active (102) est liée de manière hybride à la section d'interposeur (101) et/ou dans lequel la section active (102) comprend un ou plusieurs plots pour une liaison hybride et la section d'interposeur (101) comprend un ou plusieurs plots pour une liaison hybride.

14. Dispositif à semi-conducteur (100) selon l'une quelconque des revendications précédentes,
dans lequel les un ou plusieurs commutateurs de contact (103) forment au moins une partie de l'interface de la section d'interposeur (101) et de la section active (102).

15. Dispositif à semi-conducteur (100) selon l'une quelconque des revendications précédentes,
dans lequel, pour chaque commutateur de contact (103a), le trou d'interconnexion (104a) respectif comprend un contact en graphène destiné à être connecté thermiquement à la membrane en graphène (105a) du commutateur de contact (103a).

16. Dispositif à semi-conducteur (100) selon l'une quelconque des revendications précédentes,
dans lequel, pour chaque commutateur de contact (103a), les une ou plusieurs électrodes d'attaque entourent le trou d'interconnexion (104a) respectif depuis une vue de dessus du dispositif à semi-conducteur (100), et/ou dans lequel le trou d'interconnexion (104a) respectif est déconnecté électriquement des une ou plusieurs électrodes d'attaque.

17. Procédé (200) de fabrication d'un dispositif à semi-conducteur (100), dans lequel le procédé (200) comprend :
la fourniture (201) d'un substrat pour une section d'interposeur (101),
la gravure (202) d'une ou de plusieurs tranchées dans le substrat pour la section d'interposeur (101),
le remplissage (203) des une ou plusieurs tranchées pour former un ou plusieurs trous d'interconnexion (104),
la fourniture (204) d'un substrat pour une section active (102),
la fourniture (205) d'une ou de plusieurs membranes en graphène sur la section active (102) ou la section d'interposeur (101),
la formation (206) d'un ou de plusieurs commutateurs de contact (103) de systèmes nano-électromécaniques ou micro-électromécaniques, NEMS/MEMS, sur la base des une ou plusieurs membranes en graphène, dans lequel chaque commutateur de contact (103a) peut être commuté entre un premier état de commutation et un second état de commutation,
la liaison (207) de la section d'interposeur (101) à la section active (102), dans lequel chaque commutateur de contact (103a) des un ou plusieurs commutateurs de contact (103) est agencé entre la section d'interposeur (101) et la section active (102) et adjacent à un trou d'interconnexion (104a) respectif des un ou plusieurs trous d'interconnexion (104) de la section d'interposeur (101), de telle sorte que la membrane en graphène (105a) du commutateur de contact (103a) soit thermiquement connectée au trou d'interconnexion (104a) respectif dans le premier état de commutation et soit thermiquement déconnectée du trou d'interconnexion (104a) respectif dans le second état de commutation.

18. Procédé (200) selon la revendication 17, dans lequel le procédé (200) comprend également :
la fourniture d'une première couche comprenant une ou plusieurs premières électrodes au-dessus du substrat pour la section active (102),
la fourniture d'une deuxième couche au-dessus de la première couche comprenant une ou plusieurs sections sacrificielles et une ou plusieurs premières parties de charnière pour les un ou plusieurs commutateurs de contact (103),
la fourniture d'une troisième couche au-dessus de la deuxième couche, dans lequel la troisième couche comprend, pour chaque première électrode, une première cavité,
la fourniture, pour chaque première électrode, dans la première cavité, d'une couche sacrificielle pour recouvrir au moins une partie de la zone au-dessus de chaque première partie de charnière de deux premières parties de charnière adjacentes et pour recouvrir la zone au-dessus de la première électrode,
la croissance, pour chaque première électrode, d'une membrane en graphène (105a) au-dessus de la couche sacrificielle pour recouvrir au moins une partie de la zone au-dessus de chaque première partie de charnière des deux premières parties de charnière adjacentes et pour recouvrir la zone au-dessus de la première électrode,
le dépôt, pour chaque première électrode et pour chaque première partie de charnière des deux premières parties de charnière adjacentes, d'une seconde partie de charnière au-dessus de la première partie de charnière dans la troisième couche pour former une charnière, dans lequel au moins une partie de la membrane en graphène (105a) est prise en tenaille entre la seconde partie de charnière et la première partie de charnière, et
la libération, pour chaque première électrode, de la membrane en graphène (105a) sur la base de l'élimination de la couche sacrificielle et d'une section sacrificielle respective des une ou plusieurs sections sacrificielles.

19. Procédé (200) selon la revendication 18, dans lequel le procédé (200) comprend également :
la gravure, pour chaque première électrode, d'une seconde cavité dans la section sacrificielle respective de la deuxième couche dans une zone au-dessus de la première électrode et entre deux premières parties de charnière adjacentes des une ou plusieurs premières parties de charnière,
la fourniture, pour chaque première électrode, d'un matériau de protection sur les parois latérales de la seconde cavité vers les deux premières parties de charnière adjacentes,
la fourniture, pour chaque première électrode, d'un matériau sacrificiel dans la seconde cavité pour remplir la seconde cavité et reformer la section sacrificielle respective.

20. Procédé (200) selon la revendication 18 ou 19, dans lequel le procédé (200) comprend également :
la fourniture d'une couche de protection sur la première couche, et
la fourniture de la deuxième couche comprenant les une ou plusieurs sections sacrificielles et les une ou plusieurs premières parties de charnière au-dessus de la couche de protection.

21. Procédé (200) selon l'une des revendications 18 à 20, dans lequel les une ou plusieurs premières électrodes sont des électrodes de contre-attaque ou des électrodes d'attaque.

22. Procédé (200) selon l'une des revendications 17 à 21, dans lequel le procédé (200) comprend également la liaison de la section active (102) à la section d'interposeur (101) sur la base d'une liaison hybride.
